(19) Europäisches Patentamt / European Patent Office / Office européen des brevets

(11) **EP 2 585 837 B1**

(12) **EUROPÄISCHE PATENTSCHRIFT**

(45) Veröffentlichungstag und Bekanntmachung des Hinweises auf die Patenterteilung:
**08.08.2018 Patentblatt 2018/32**

(51) Int Cl.:
**G01R 13/02** *(2006.01)*     **G01R 19/02** *(2006.01)*

(21) Anmeldenummer: **11724174.5**

(22) Anmeldetag: **01.06.2011**

(86) Internationale Anmeldenummer:
**PCT/EP2011/059074**

(87) Internationale Veröffentlichungsnummer:
**WO 2011/160931 (29.12.2011 Gazette 2011/52)**

(54) **MESSVORRICHTUNG UND VERFAHREN ZUR DEZIMATION EINES DATENSTROMS**

MEASURING APPARATUS AND METHOD FOR DECIMATING A DATA STREAM

DISPOSITIF DE MESURE ET PROCÉDÉ DE DÉCIMATION D'UN FLUX DE DONNÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.09.2010 DE 102010046437**
**23.06.2010 DE 102010024707**

(43) Veröffentlichungstag der Anmeldung:
**01.05.2013 Patentblatt 2013/18**

(73) Patentinhaber: **Rohde & Schwarz GmbH & Co. KG**
**81671 München (DE)**

(72) Erfinder: **REICH, Friedrich**
**86391 Stadtbergen (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A1- 0 916 956**     **EP-A1- 0 977 043**
**WO-A1-2005/101032**     **DE-A1-102007 053 401**
**US-A1- 2003 110 194**     **US-B1- 6 380 874**

- **HARRIS J M ET AL: "16-channel PC-based aircraft electrical power monitor", PROCEEDINGS OF THE INSTRUMENTATION AND MEASUREMENT TECHNOLOGY CONFERENCE. ORVINE, CA., MAY 18 - 20, 1993; [PROCEEDINGS OF THE INSTRUMENTATION AND MEASUREMENT TECHNOLOGY CONFERENCE], NEW YORK, IEEE, US, Bd. -, 18. Mai 1993 (1993-05-18), Seiten 637-642, XP010131406, DOI: 10.1109/IMTC.1993.382565 ISBN: 978-0-7803-1229-6**
- **WANG YU-LING ET AL: "Identifying Gravel Layer Using Time-Domain Analysis Methods for Landfill Leak Repair", MEASURING TECHNOLOGY AND MECHATRONICS AUTOMATION (ICMTMA), 2010 INTERNATIONAL CONFERENCE ON, IEEE, PISCATAWAY, NJ, USA, 13. März 2010 (2010-03-13), Seiten 406-409, XP031672043, ISBN: 978-1-4244-5001-5**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf eine Messvorrichtung und ein Verfahren zur Dezimation von Abtastwerten innerhalb eines Oszilloskops

Bei Oszilloskopen kann die Zeitbasis (Skalierung der Zeitachse) in einem weiten Bereich von z.B. 20 ps/div bis z.B. 50 s/div eingestellt werden. Bei digitalen Oszilloskopen bestimmt die Zeitbasis, wie lange das Signal aufgezeichnet werden muss. Weiterhin findet innerhalb von digitalen Oszilloskopen die Analog/Digital-Umsetzung der Abtastwerte bevorzugt mit einer konstanten, nicht veränderbaren, Geschwindigkeit der Analog/Digital-Wandler statt. Die Geschwindigkeit der Analog/Digital-Wandler orientiert sich dabei an der maximalen Samplingrate des entsprechenden Oszilloskops. Bedingt durch den großen Bereich, den die Zeitbasis überstreicht, ist es nicht immer möglich, mit der vollen Abtastrate des Analog/Digital-Wandlers aufzuzeichnen. Beträgt die Geschwindigkeit des Analog/Digitalwandlers z.B. 10 GSample/s und ist die Zeitbasis auf 1 s/div eingestellt und kann die Bildschirmeinheit des Oszilloskops 10 Divisionen anzeigen, dann müssten 100 GSample aufgenommen, gespeichert und verarbeitet werden. Derartige schnelle und große Speicher, sowie die dazu notwendige Signalverarbeitung sind technisch entweder nicht realisierbar oder unverhältnismäßig aufwendig, zumal die Bildschirmeinheit ohnehin nicht über die notwendige Auflösung verfügt, um mehrere Millionen Abtastwerte darzustellen.

Aus diesem Grund wird in digitalen Oszilloskopen, je nach Skalierung der Zeitachse, nicht mehr zwingend jeder Abtastwert gespeichert und dargestellt, sondern die Abtastwerte werden vor dem Speichern dezimiert. Verschiedene Verfahren sind dabei aus dem Stand der Technik bekannt.

Aus der DE 10 2007 053 401 A1 sind ein Verfahren und eine Vorrichtung bekannt, mit denen es ermöglicht ist, dass ein Datenstrom gleichzeitig mit mehreren Dezimationsarten dezimiert werden kann. Vorgestellte Dezimationsarten sind dabei die Selektions-Dezimation, die Mittelwert-Dezimation und die Maximalwert-Dezimation. Sollen die Abtastwerte z.B. um den Faktor 1000 dezimiert werden, dann wird bei der Selektions-Dezimation aus einem Zeitabschnitt von 1000 Abtastwerten willkürlich ein Abtastwert ausgewählt und die restlichen Abtastwerte werden verworfen. Bei der Mittelwert-Dezimation wird aus dem Zeitabschnitt von 1000 Abtastwerten der Mittelwert gebildet und gespeichert, wohingegen bei der Maximalwert-Dezimation aus dem Zeitabschnitt von 1000 Abtastwerten nur der Minimalwert und der Maximalwert gespeichert werden. Nachteilig an der DE 10 2007 053 401 A1 ist, dass keines der verwendeten Dezimationsverfahren es zulässt einen Effektivwert eines bevorzugt periodischen Signals sehr genau zu berechnen und anzeigen zu können.

Es ist daher die Aufgabe der Erfindung eine Messvorrichtung und ein Verfahren zu schaffen, welche es erlauben sehr genau den Effektivwert eines Signals anzeigen zu können.

Die Aufgabe wird bezüglich der Messvorrichtung durch die Merkmale des Anspruchs 1 und bezüglich des Verfahrens durch die Merkmale des Anspruchs 8 gelöst. In den Unteransprüchen sind vorteilhafte Weiterbildungen der erfindungsgemäßen Messvorrichtung und des erfindungsgemäßen Verfahrens angegeben.

Die erfindungsgemäße Messvorrichtung, insbesondere für ein Oszilloskop, weist eine Dezimationseinheit auf, wobei die Dezimationseinheit zumindest einen Eingang aufweist, der von zumindest einer Datenquelle einen Datenstrom mit einer Vielzahl von Abtastwerten empfängt. Die Dezimationseinheit weist einen Ausgang auf, an dem ein reduzierter Datenstrom ausgegeben wird, wobei der reduzierte Datenstrom aus einem von der Dezimationseinheit berechneten quadratischen Mittelwert aus jeweils zumindest zwei Abtastwerten gebildet ist.

Besonders vorteilhaft ist es, wenn die Messvorrichtung aus zumindest zwei Abtastwerten des Datenstroms den reduzierten Datenstrom berechnet, der einen quadratischen Mittelwert von den zumindest zwei Abtastwerten enthält. Dadurch kann direkt der Effektivwert eines bevorzugt periodischen Signals sehr genau angezeigt werden. Dieser ist z. B. zur Analyse von Netzteilen oder Hochfrequenz-Endstufen von enormer Bedeutung. Unter der Bildung eines quadratischen Mittelwerts wird auch die Bildung eines RMS-Werts (engl. root mean square) verstanden.

Das erfindungsgemäße Verfahren zur Dezimation eines Datenstroms, insbesondere für ein Oszilloskop, weist eine Dezimationseinheit auf, deren zumindest einer Eingang den Datenstrom mit einer Vielzahl von Abtastwerten von zumindest einer Datenquelle empfängt und an deren Ausgang ein reduzierter Datenstrom ausgegeben wird. In einem ersten Verfahrensschritt werden Parameter, wie der Zeitbereich und/oder der Spannungsbereich, eingestellt. In einem zweiten Verfahrensschritt wird der reduzierte Datenstrom aus einem von der Dezimationseinheit berechneten quadratischen Mittelwert aus jeweils zumindest zwei Abtastwerten gebildet.

Ein besonderer Vorteil besteht, wenn das Verfahren aus zumindest zwei Abtastwerten des Datenstroms den reduzierten Datenstrom berechnet, der einen quadratischen Mittelwert von den zumindest zwei Abtastwerten enthält. Dabei besteht in der Analyse von modulierten Signalen, wie z.B. von amplitudenmodulierten Signalen, ein erheblicher Vorteil, weil das Modulationssignal durch Verlangsamen der Zeitbasis direkt sichtbar gemacht werden kann.

Ein weiterer Vorteil der erfindungsgemäßen Messvorrichtung besteht, wenn eingestellte Werte für einen Offset bei der Berechnung des quadratischen Mittelwerts durch die Dezimationseinheit berücksichtigt werden. Dadurch kann z.B. ein Gleichanteil innerhalb eines bevorzugt periodischen Signals eliminiert werden. Bei dem erfindungsgemäßen Verfahren werden mehrere Datenquellen, die jeweils eine Vielzahl an Abtastwerten liefern, an die Dezimationseinheit angeschlossen und die Dezimationseinheit berechnet parallel einen quadratischen Mittelwert aus jeweils zumindest zwei Abtastwerten jeder Datenquelle. Dies erlaubt z.B. die parallele Dezimierung von Abtastwerten von verschiedenen Kanälen mittels der quadratischen Mittelwertbildung. Es kann damit z.B. der Effektivwert eines bevorzugt periodischen Signals an verschiedenen Stellen innerhalb der zu analysierenden Schaltung zur selben Zeit gemessen werden.

Eine Triggereinheit 12 vergleicht eine Vielzahl von Abtastwerten für jede Datenquelle 4, 14 mit einem für jede Datenquelle 4, 14 individuell einstellbaren Schwellwert. Sobald ein Datenstrom 5, 16 einen für ihn eingestellten Schwellwert überschreitet, gibt die Triggereinheit 12 ein Triggersignal 13 an eine Aufzeichnungssteuerung 8 über eine Aufzeichnungseinheit 7 aus.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:

Fig. 1    ein Blockschaltbild eines Ausführungsbeispiels der Messvorrichtung, die die erfindungsgemäße Dezimationseinheit enthält;

Fig. 2    eine Tabelle mit beispielhaften Abtastwerten zur Verdeutlichung der Funktionsweise der erfindungsgemäßen Dezimationseinheit;

Fig. 3    ein Bildschirmausschnitt mit einem beispielhaften amplitudenmodulierten Signal zur Verdeutlichung der erfindungsgemäßen Dezimationseinheit;

Fig. 4    ein weiter Bildschirmausschnitt mit einem Modulationssignal zur Verdeutlichung der erfindungsgemäßen Dezimationseinheit; und

Fig. 5    ein Flussdiagramm zur Verdeutlichung eines Ausführungsbeispiels für das erfindungsgemäße Verfahren zur Dezimation von Abtastwerten.

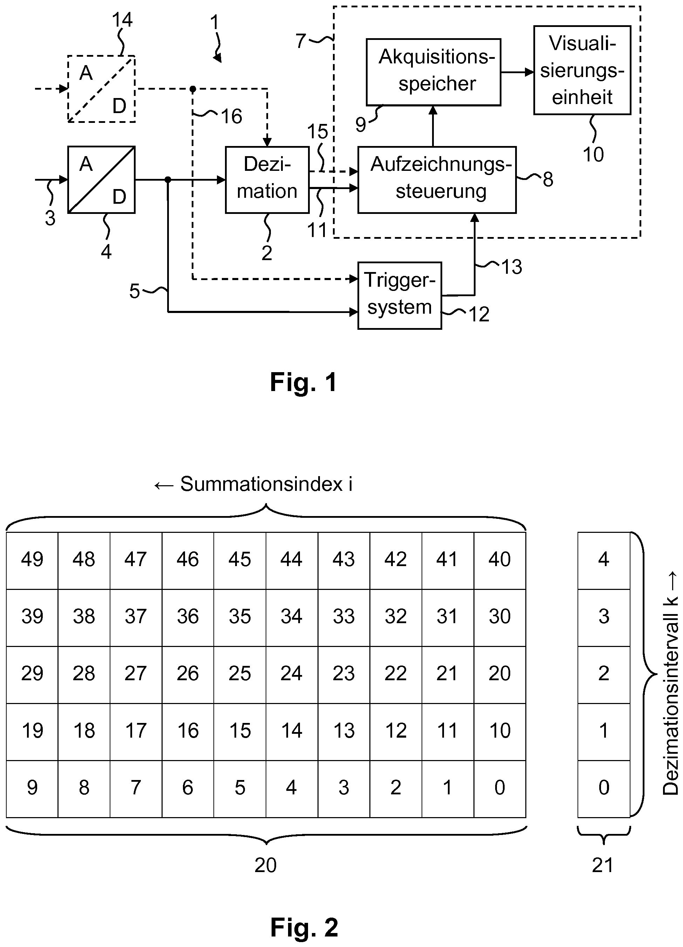

Ein Ausführungsbeispiel der Messvorrichtung 1 mit der erfindungsgemäßen Dezimationseinheit 2 ist in Fig. 1 dargestellt und wird im Folgenden näher erläutert.

Ein analoges Messsignal 3 wird in einem Analog/DigitalWandler 4 in sein korrespondierendes Datenformat gewandelt. Bei dem Analog/Digitalwandler 4 wird auch von einer Datenquelle 4 gesprochen. Die Datenquelle 4 stellt dabei an ihrem Ausgang einen digitalen Datenstrom 5 zu Verfügung. Dieser Datenstrom 5 beinhaltet eine Vielzahl von Abtastwerten. Der Datenstrom 5 wird von der Dezimationseinheit 2 an ihrem zumindest einen Eingang empfangen. Optional kann zwischen der Datenquelle 4 und der Dezimationseinheit 2 noch ein Entzerrungsfilter geschaltet sein, in welchem eine Entzerrung des linear, bzw. nichtlinear verzerrten Datenstroms 5 erfolgt.

Bei dem Datenstrom 5 kann es sich um einen digitalisierten Spannungsverlauf oder um einen digitalisierten Stromverlauf des analogen Messsignals 3 handeln.

Ein Ausgang der Dezimationseinheit 2 ist mit einer Aufzeichnungseinheit 7 verbunden. Innerhalb der Aufzeichnungseinheit 7 sind eine Aufzeichnungssteuerung 8, ein Akquisitionsspeicher 9 und eine Visualisierungseinheit 10 ausgebildet. Die Aufzeichnungssteuerung 8 ist dabei mit zumindest einem Ausgang der Dezimationseinheit 2 verbunden. Über diesen Ausgang der Dezimationseinheit 2 empfängt die Aufzeichnungssteuerung 8 einen reduzierten Datenstrom 11. Der reduzierte Datenstrom 11 ist aus einem von der Dezimationseinheit 2 berechneten quadratischen Mittelwert von jeweils zumindest zwei Abtastwerten aus dem Datenstrom 5 gebildet. Eine genaue Erläuterung, wie diese Berechnung stattfindet, wird in den weiteren Beschreibungen gegeben.

Der Datenstrom 5 mit einer Vielzahl von Abtastwerten wird außerdem noch einem Eingang einer Triggereinheit 12 zugeführt. Ein Ausgang der Triggereinheit 12 ist mit der Aufzeichnungseinheit 7 und in dieser mit der Aufzeichnungssteuerung 8 verbunden. In der Triggereinheit 12 wird der Datenstrom 5 mit einer Vielzahl von Abtastwerten mit einstellbaren Schwellwerten zur Erzeugung eines Triggersignals 13 verglichen. Das Triggersignal 13 wird anschließend über eine Datenverbindung an die Aufzeichnungseinheit 7 und in dieser an die Aufzeichnungssteuerung 8 weitergeleitet.

Die Aufzeichnungssteuerung 8 beinhaltet noch einen nicht dargestellten Ringpuffer, in welchem der reduzierte Datenstroms 11 abgespeichert ist. Sobald die Aufzeichnungssteuerung 8 das Triggersignal 13 über die Aufzeichnungseinheit 7 von der Triggereinheit 12 empfängt, werden die Abtastwerte, die in dem nicht dargestellten Ringspeicher innerhalb der Aufzeichnungssteuerung 8 gespeichert sind, durch die Aufzeichnungssteuerung 8 innerhalb der Aufzeichnungseinheit 7 in den Akquisitionsspeicher 9 der Aufzeichnungseinheit 7 gespeichert. Die genaue Auswahl, welche Abtastwerte in den Akquisitionsspeicher 9 gespeichert werden sollen, hängt unter anderem von der gewählten Position des Triggerzeitpunkts ab.

Der Akquisitionsspeicher 9 innerhalb der Aufzeichnungseinheit 7 ist mit der Visualisierungseinheit 10 verbunden. Die Visualisierungseinheit 10 stellt auf einer nicht dargestellten Bildschirmeinheit, die von der Aufzeichnungssteuerung 8 innerhalb der Aufzeichnungseinheit 7 selektierten Vielzahl von Abtastwerten aus dem reduzierten Datenstrom 11 dar.

Von Bedeutung ist dabei, dass der Triggereinheit 12 der nicht dezimierte Datenstrom 5 zugeführt ist und dass die Aufzeichnungssteuerung 8 über die Aufzeichnungseinheit 7 nur einen dezimierten Datenstrom 11 von der Dezimationseinheit 2 erhält. Zwischen der Datenquelle 4 und der Triggereinheit 12 kann optional noch ein Tiefpass ausgebildet sein, der ein gegenüber dem Datenstrom 5 höherfrequentes Rauschsignal bandbegrenzt.

Bevorzugt weist die Dezimationseinheit 2 noch weitere Datenquellen 14 auf. Bei diesen weiteren Datenquellen 14 handelt es sich bevorzugt ebenfalls um Analog/DigitalWandler, die mit den weiteren Eingangskanälen der Messvorrichtung 1, die bevorzugt ein Oszilloskop darstellt, verbunden sind. Diese weitere Datenquelle 14 ist gestrichelt dargestellt, um auszudrücken, dass es sich dabei um eine unbestimmte Anzahl an einzelnen Datenquellen 14 handeln kann. Die weitere Datenquelle 14 ist mit einem weiteren Eingang der Triggereinheit 12 und mit einem weiteren Eingang der Dezimationseinheit 2 verbunden. Die weiteren Datenquellen 14, die an die Dezimationseinheit 2 angeschlossen sind, liefern dieser jeweils eine Vielzahl von Abtastwerten. Die Dezimationseinheit 2 berechnet einen quadratischen Mittelwert aus jeweils zumindest zwei Abtastwerten jeder weiteren Datenquelle 14. Diese Berechnung erfolgt bevorzugt parallel für alle Datenquellen 4, 14. Die Dezimationseinheit 2 weist für jede Datenquelle 4, 14 einen eigenen Ausgang auf, wobei an jedem Ausgang ein reduzierter Datenstrom 11, 15 für jede Datenquelle 4, 14 bereit gestellt ist und der Aufzeichnungssteuerung 8 über die Aufzeichnungseinheit 7 übergeben wird.

Die Triggereinheit 12 vergleicht eine Vielzahl von Abtastwerten für jede Datenquelle 4, 14 mit einem für jede Datenquelle 4, 14 individuell einstellbaren Schwellwert. Sobald ein Datenstrom 5, 16 einen für ihn eingestellten Schwellwert überschreitet, gibt die Triggereinheit 12 das Triggersignal 13 an die Aufzeichnungssteuerung 8 über die Aufzeichnungseinheit 7 aus. Die Triggereinheit 12 kann dabei für jede Datenquelle 4, 14 auch einen eigenen Triggertyp anwenden. So kann eine Datenquelle 4 z.B. auf eine steigende Flanke, eine andere Datenquelle 14 z.B. auf eine Fallende Flanke und wieder eine andere Datenquelle 14 z.B. auf ein bestimmtes Bitmuster oder z.B. auf eine bestimmte Pulsbreite getriggert werden.

Fig. 2 zeigt eine Tabelle mit beispielhaften Abtastwerten zur Verdeutlichung der Funktionsweise der erfindungsgemäßen Dezimationseinheit 2. Die Dezimationseinheit 2 reduziert dabei den Datenstrom 5 um einen Dezimationsfaktor D und gibt einen um den Dezimationsfaktor reduzierten Datenstrom 11 an ihrem Ausgang aus. Bei modernen Oszilloskopen ist die Geschwindigkeit der Datenquelle 4 konstant, bevorzugt auf ihren schnellsten Wert eingestellt, damit gewährleistet ist, dass die Triggereinheit 12, die zu triggernde Stelle innerhalb des Messsignals bestmöglich erkennt. Liefert eine Datenquelle 4 einen Datenstrom 5 mit einer Datenrate von z.B. 10 GSample/s, dann wird alle 100 ps ein Messwert aufgenommen. Weist eine an die Visualisierungseinheit 10 angeschlossene Bildschirmeinheit eine Auflösung von z.B. 1000 Bildpunkten in der Horizontalen auf, dann können maximal 1000 Abtastwerte, bei der zuvor eingestellten Datenrate der Datenquelle 4 gleichzeitig angezeigt werden. Dies entspricht einem Zeitbereich von 100 ns. Möchte man nun einen Zeitraum von 1 μs betrachten, dann kann nur jeder zehnte Abtastwert angezeigt werden. Die von der Datenquelle 4 gelieferte Vielzahl an Abtastwerten muss nun in der Dezimationseinheit 2 um den Dezimationsfaktor D = 10 dezimiert bzw. reduziert werden.

In Fig. 2 sind beispielhaft die Werte von fünfzig Abtastwerten in einer ersten Tabelle 20 dargestellt. Der erste Abtastwert weist den Wert null auf, der fünfzigste Abtastwert weist den Wert 49 auf. Diese Vielzahl von Abtastwerten soll nun gemäß dem erfindungsgemäßen Dezimationsverfahren dezimiert werden. Die Tabelle 20 weist fünf Zeilen mit je zehn Spalten auf. Eine zweite Tabelle 21, weist ebenfalls fünf Zeilen mit nur einer Spalte auf. Die zweite Tabelle 21 beinhaltet das Dezimationsintervall k. Die erfindungsgemäße Dezimationseinheit 2 arbeitet bevorzugt nach Gleichung (1) :

$$u_{RMS}(k) = \sqrt{\frac{1}{D} \sum_{i=0}^{D-1} (u(k \cdot D + i))^2} \qquad (1)$$

wobei sich der quadratische Mittelwert (engl. root mean square (RMS)) mit

D = Dezimierungsfaktor
k = Dezimationsintervall
u = Abtastwert
i = Summationsindex

berechnet.

Im obigem Beispiel soll die Vielzahl an Abtastwerten um den Dezimationsfaktor D = 10 dezimiert werden. Jede Zeile von Tabelle 20 in Fig. 2 enthält bereits 10 Abtastwerte aus denen jeweils der quadratische Mittelwert gebildet wird. In Gleichung (1) werden die einzelnen Zeilen der Tabelle 20 über das Dezimationsintervall k, beginnend bei null, adressiert. Das Dezimationsintervall k ist zur Verdeutlichung in Tabelle 21 aufgetragen. Der Summationsindex i, der auch als Laufindex i bezeichnet wird, dient dazu, die einzelnen Abtastwerte innerhalb jedes Dezimationsintervalls k genau zu adressieren. Für die erste Zeile in der Tabelle 20 berechnet sich der quadratische Mittelwert nach Gleichung (2):

$$u_{RMS} = \sqrt{\frac{1}{10} \cdot (0^2 + 1^2 + 2^2 + 3^2 + 4^2 + 5^2 + 6^2 + 7^2 + 8^2 + 9^2)} \qquad (2)$$

zu

$$u_{RMS} \sim 5{,}34 \qquad (3).$$

Die anderen Dezimationsintervalle k berechnen sich analog dazu.

Der reduzierte Datenstrom 11 am Ausgang der Dezimationseinheit 2 beinhaltet statt den ursprünglichen fünfzig Abtastwerten schlussendlich noch fünf Abtastwerte, die innerhalb des Ringspeichers der Aufzeichnungssteuerung 8 gespeichert sind. Sobald die Triggereinheit 12, die alle fünfzig Abtastwerte des Datenstroms 5 gegenüber einem einstellbaren Triggerkriterium vergleicht, ein Triggersignal 13 über die Aufzeichnungseinheit 7 an die Aufzeichnungssteuerung 8 ausgibt, speichert die Aufzeichnungssteuerung 8 den in ihrem Ringspeicher befindlichen reduzierten Datenstrom 11 im Akquisitionsspeicher 9 ab. Eine an die Visualisierungseinheit 10 angeschlossene Bildschirmeinheit stellt den im Akquisitionsspeicher 9 gespeicherten reduzierten Datenstrom 11 dar. Dabei kann dann der dezimierte Abtastwert 5,34 z.B. auf dem vertikalen Bereich des ersten Bildpunkts angezeigt werden.

Ist das analoge Messsignal 3 mit einem Offsetwert $V_{off}$ behaftet, dann kann dieser Offsetwert $V_{off}$ in der Dezimationseinheit 2 berücksichtigt werden. Eine Formel für die quadratische Mittelwertbildung unter Berücksichtigung eines Offsetwerts $V_{off}$ ist in Gleichung (4) angegeben:

$$u_{RMS}(k) = \sqrt{\frac{1}{D} \sum_{i=0}^{D-1} (u(k \cdot D + i + v_{off}))^2} \qquad (4)$$

.

Der Offsetwert $V_{off}$ wird dabei direkt zu jedem Abtastwert addiert.

In einem weiteren erfindungsgemäßen Ausführungsbeispiel wird der quadratische Mittelwert durch die Dezimationseinheit 2 nicht von jedem Abtastwert in dem Dezimationsintervall k gebildet, sondern so dass nur jeder n-te Abtastwert in die Bildung des quadratischen Mittelwerts eingeht. Eine Formel hierfür ist in Gleichung (5) gegeben:

$$u_{RMS}(k) = \sqrt{\frac{1}{D} \sum_{i=0}^{\frac{D-1}{n}} (u(k \cdot D + n \cdot i))^2} \qquad mit \ \frac{D-1}{n} \in \mathbb{N} \ \cap \ n > 1 \quad (5)$$

.

Bei n handelt es sich um einen sogenannten kleinen Dezimierungsfaktor.

Diese Art der Dezimierung kann insbesondere dann sinnvoll angewandt werden, wenn die Varianz der Abtastwerte des Datenstroms 5 gering ist. Dadurch kann die notwendige Rechenleistung der Dezimationseinheit 2 reduziert werden, bzw. auch eine die Rechenleistung betreffende schwächere Dezimationseinheit 2 kann dadurch eine Vielzahl von Datenströmen 5, 14 parallel dezimieren.

Es ist natürlich auch in Gleichung (5) möglich, dass etwaige Offsetwerte $V_{off}$ berücksichtigt werden. Hierzu werden die Offsetwerte $V_{off}$ in Gleichung (5), wie zuvor in Gleichung (4), hinzuaddiert.

In einem weiteren erfindungsgemäßen Ausführungsbeispiel wird der quadratische Mittelwert innerhalb eines Dezimationsintervalls k einzig aus dem maximalen und dem minimalen Abtastwert, die in dem Dezimationsintervalls k enthalten sind, gebildet.

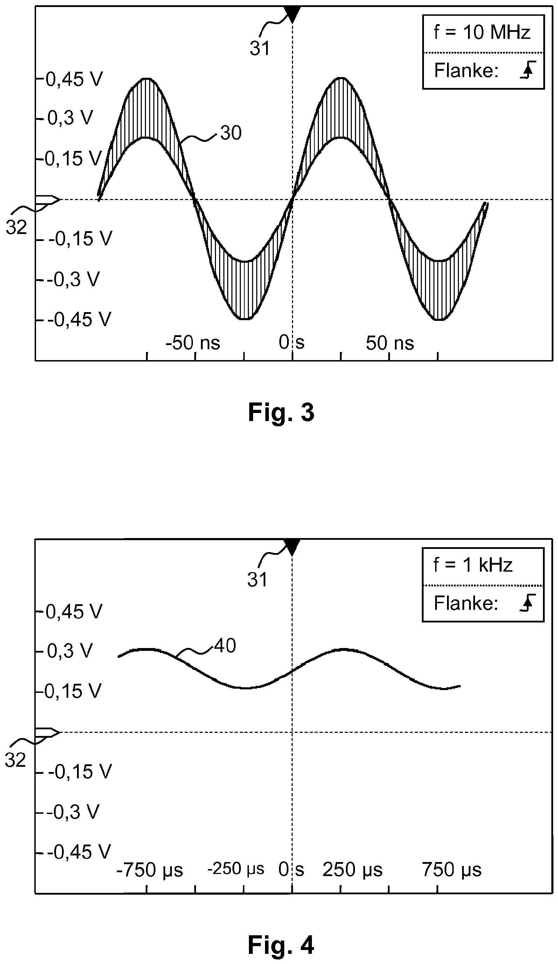

Fig. 3 zeigt ein Bildschirmausschnitt mit einem beispielhaften amplitudenmodulierten Signal 30 zur Verdeutlichung der erfindungsgemäßen Dezimationseinheit 2. Das dargestellte amplitudenmodulierte Signal 30 weist eine Frequenz von in Beispiel 10 MHz auf, die Periodendauer beträgt dabei 100 ns. Der Cursor für den Triggerzeitpunkt 31 liegt in der Mitte des Bildschirmausschnitts und der Cursor für die Triggerschwelle 32 liegt bei 0 V. Die Triggereinheit 12 triggert auf eine steigende Flanke des amplitudenmodulierten Signals 30. Der Zeitbereich ist derart skaliert, dass er ungefähr einen Bereich von 200 ns abdeckt. Die Dezimationseinheit 2 ist bei der Aufnahme des Bildschirmausschnitts ausgeschaltet, was bedeutet, dass die Bildschirmeinheit beispielhaft eine Auflösung von 2000 Bildpunkten auf der Horizontalen besitzt, bei einer Datenrate der Datenquelle von 10 GSample/s. Die hohe Frequenz des Modulationssignals von 1 kHz und die langsame Bildwiederholrate der Bildschirmeinheit führen zur Entstehung sogenannter Schattenbilder. Der Bildschirmausschnitt zeigt das amplitudenmodulierte Signal 30 einmal mit der maximalen und einmal mit der minimalen Amplitude.

Um ein solches amplitudenmoduliertes Signal 30 zu demodulieren, sind im einfachsten Fall eine Gleichrichtung mittels einer Diode und eine Glättung mittels eines Ladekondensators notwendig. Parallel zu dem Ladekondensator ist meist noch ein Entladewiderstand angeordnet, wobei die Zeitkonstante der Kombination aus Ladekondensator und Entladewiderstand größer sein muss, als die Periodendauer des hochfrequenten Trägers, und kleiner sein muss, als die Periodendauer des Modulationssignals. Bei Betrachtung der Formel für die quadratische Mittelwertbildung aus Gleichung (1) ist festzustellen, dass die Gleichrichtung durch die Quadrierung und das anschließende Ziehen der Wurzel erfolgt. Die Glättung selbst erfolgt durch die Mittelwertbildung, so dass allein durch den Einsatz einer Dezimationseinheit 2, die den quadratischen Mittelwert bildet, eine Demodulierung eines amplitudenmodulierten Signals 30 möglich ist. Diese Demodulierung erfolgt automatisch bei Verwendung der erfindungsgemäßen Dezimationseinheit 2, wie in Fig. 4 erläutert wird.

Fig. 4 zeigt einen weiteren Bildschirmausschnitt mit einem Modulationssignal 40 zur Verdeutlichung der erfindungsgemäßen Dezimationseinheit 2. Die Zeitachse ist in Fig. 4, im Vergleich zu der Zeitachse aus Fig. 3, um den Faktor 10 000 nach oben skaliert. Statt eines Zeitbereichs von insgesamt 200 ns, zeigt die Zeitachse aus Fig. 4 einen Zeitbereich von insgesamt 2 ms an. Der Dezimationsfaktor D beträgt in diesem Fall 10 000. Die Skalierung des Spannungsbereichs ist unverändert. Zu erkennen ist das Modulationssignal 40, mit dem das Trägersignal moduliert wurde. Bei diesem Modulationssignal 40 handelt es sich um ein bevorzugt periodisches Signal mit einer Frequenz von 1 kHz. Das Signal muss allerdings nicht zwingend periodisch sein. Amplitudenmodulierte Signale sind z.B. im Allgemeinen nicht periodisch. Die Demodulation gelingt durch Verstellen des Zeitbereichs und zwar in dem Maße, dass der ausgewählte Zeitbereich zwischen der Periodendauer des hochfrequenten Trägers und der Periodendauer des Modulationssignals 40 liegt. Bei herkömmlichen Oszilloskopen kann dieser Zeitbereich sehr einfach und schnell eingestellt werden. Wird der Zeitbereich zu klein gewählt, dann handelt es sich bei dem dargestellten Signal nur um das gleichgerichtete amplitudenmodulierte Signal 30. Wird der Zeitbereich zu groß gewählt, dann ist das Modulationssignal 40 zu stark geglättet und stellt unter Umständen nur noch eine horizontale Linie dar.

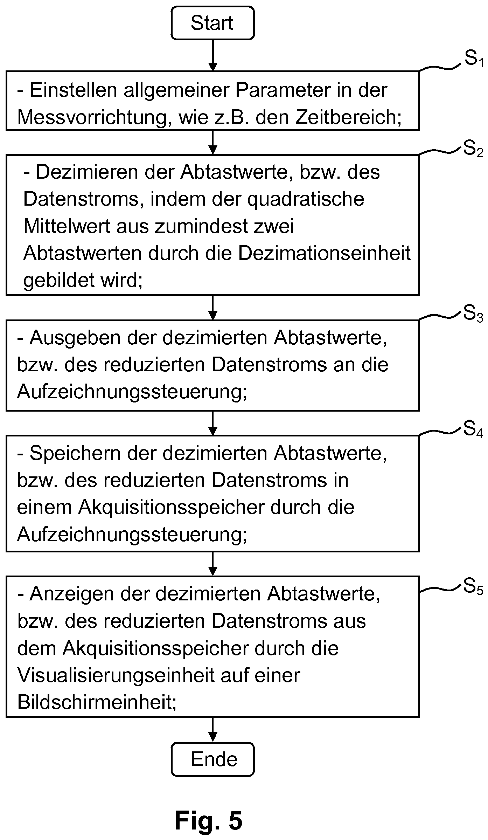

Fig. 5 zeigt ein Flussdiagramm zur Verdeutlichung eines Ausführungsbeispiels für das erfindungsgemäße Verfahren zur Dezimation von Abtastwerten. Die Dezimationseinheit 2 empfängt dabei an zumindest einem Eingang einen Datenstrom 5, der eine Vielzahl an Abtastwerten enthält, von zumindest einer Datenquelle 4. An einem Ausgang der Dezimationseinheit 2 wird dabei zumindest ein reduzierter Datenstrom 11 ausgegeben.

In einem ersten Verfahrensschritt $S_1$ werden grundlegende Parameter der Messvorrichtung 1, bei welcher es sich bevorzugt um ein Oszilloskop handelt, eingestellt. Eingestellt werden dabei allgemeine Parameter, wie z.B. der Zeitbereich und/oder der Pegelbereich, wie z.B. der Spannungsbereich bzw. Strombereich, und/oder die Triggerschwelle und/oder der Triggerzeitpunkt und/oder der Triggertyp, auf den die Triggereinheit 8 triggert, und/oder der zu messende Kanal und/oder der Abschlusswiderstand am Messeingang. Die Einstellung des Abschlusswiderstands ist dabei zum Zwecke der Leistungsberechnung notwendig. Damit kann der Effektivwert eines analogen Messsignals 3 auch über die Zeit dargestellt werden. Diese Einstellungen können z.B. durch ein mit der Messvorrichtung 1 verbundenes Computersystem automatisiert vorgenommen werden.

In einem zweiten Verfahrensschritt $S_2$ wird ein reduzierter Datenstrom 11 aus einem von der Dezimationseinheit 2 berechneten quadratischen Mittelwert von jeweils zumindest zwei Abtastwerten gebildet. Es kann auch davon gesprochen werden, dass die Abtastwerte reduziert werden, wozu mindestens zwei Abtastwerte notwendig sind, aus denen ein gemeinsamer quadratischer Mittelwert gebildet wird. Die quadratische Mittelwertbildung erfolgt gemäß einer der Gleichungen (1) oder (2) oder (3), wobei auch in Gleichung (3) ein Offsetwert $V_{off}$ mit berücksichtigt werden kann. Der Dezimationsfaktor D bestimmt sich dabei nach der Datenrate der Datenquelle 4, der Größe des Akquisitionsspeichers 9 und der Skalierung des Zeitbereichs bzw. nach der maximal anzeigbaren Bildpunkte auf der Bildschirmeinheit. Dabei gilt, dass je höher die Datenrate der Datenquelle 4 ist, je kleiner der Akquisitionsspeicher 9 ist, und je größer der Zeitbereich ist, der Dezimationsfaktor D umso größer gewählt werden muss.

In einem dritten Verfahrensschritt $S_3$ wird der reduzierte Datenstrom 11 an einem Ausgang der Dezimationseinheit 2 über die Aufzeichnungseinheit 7 an die Aufzeichnungssteuerung 8 ausgegeben und innerhalb dieser in einem Ringspeicher gespeichert. Der reduzierte Datenstrom 11 besteht dabei aus den mit dem Dezimationsfaktor D dezimierten Abtastwerten.

In einem vierten Verfahrensschritt $S_4$ wird der reduzierte Datenstrom 11 durch die Aufzeichnungssteuerung 8 in einem Akquisitionsspeicher 9 gespeichert, sobald die Triggereinheit 12 ein Triggersignal 13 über die Aufzeichnungseinheit 7 an die Aufzeichnungssteuerung 8 ausgibt. Bei dem zu speichernden reduzierten Datenstrom 11 handelt es sich auch um die dezimierten Abtastwerte. Es werden bevorzugt nur so viele Abtastwerte gespeichert, wie die Bildschirmeinheit auch anzeigen kann. Ist der Akquisitionsspeicher groß genug, dann können auch mehr Abtastwerte gespeichert werden, als durch die Bildschirmeinheit angezeigt werden können. In diesem Fall kann der Betrachtungszeitpunkt geändert oder die Zeitachse neu skaliert werden, ohne dass erneut Abtastwerte erfasst werden müssten.

In einem fünften Verfahrensschritt $S_5$ wird der in dem Akquisitionsspeicher 9 gespeicherte reduzierte Datenstrom 11 durch die Visualisierungseinheit 10 auf einer Bildschirmeinheit angezeigt. Bei dem reduzierten Datenstrom 11 handelt es sich auch um die dezimierten Abtastwerte.

Der Datenstrom 5 mit seiner Vielzahl an Abtastwerten kann sich sowohl auf eine gemessene Spannung, als auch auf einen gemessenen Strom, als auch auf eine andere physikalische Größe beziehen. Der Offsetwert $V_{off}$ kann eine Offsetspannung oder ein Offsetstrom oder der Offset (Versatz) einer anderen physikalischen Größe sein und beliebig eingestellt werden. Diese Einstellung erfolgt bevorzugt durch ein mit der Messvorrichtung 1 verbundenes Computersystem.

Außerdem ist es möglich, dass weitere Datenquellen 14, von denen jede Einzelne eine Vielzahl an Abtastwerten an die Dezimationseinheit 2 liefert, an diese angeschlossen werden. Die Dezimationseinheit 2 bildet dann aus zumindest zwei Abtastwerten von jeder Datenquelle 14 einen quadratischen Mittelwert, wobei die quadratischen Mittelwerte für jede der weiteren Datenquelle 14 zueinander bevorzugt parallel berechnet werden. Eine serielle Berechnung der quadratischen Mittelwerte ist ebenfalls möglich.

Die Dezimation mittels Bildung eines quadratischen Mittelwertes über eine Vielzahl an Abtastwerten kann auch in anderen Messvorrichtungen, als einem Oszilloskop, verwendet werden.

Die Dezimation kann überdies nicht nur auf einen Datenstrom 5, 16 kommend von einem Analog/Digital-Wandler angewendet werden, sondern auf jeden beliebigen digitalen Datenstrom.

Bei sehr hohen Datenraten kann der Datenstrom 5, 16 kommend von dem Analog/Digital-Wandler auch direkt in der Akquisitionsspeichereinheit 9 gespeichert werden. Die Dezimation erfolgt dann nach Beendigung der Aufzeichnungsphase.

Es ist auch möglich, dass verschiedene Dezimationsarten parallel an einem Datenstrom 5, 16 ausgeführt werden. In diesem Fall handelt es sich bei dem Datenstrom 11, 15 am Ausgang der Dezimationseinheit 2 nicht um einen reduzierten Datenstrom. Die Wortbreite des Datenstroms 11, 15 am Ausgang der Dezimationseinheit 2 kann dann höher sein, als bei dem Datenstrom 5, 16 am Eingang der Dezimationseinheit 2. Die Aufgabe der Dezimationseinheit 2 besteht in diesem Fall nicht in der Datenreduktion innerhalb des Datenstroms 5, 16, um dadurch den Nachverarbeitungsaufwand zu senken, sondern in der gleichzeitigen Darstellung von unterschiedlichen Informationen des Datenstroms 5, 16, wie z.B. den Effektivwert über die Zeit und parallel dazu z.B. den Peak-Wert (dt. Scheitelwert).

## Patentansprüche

1. Messvorrichtung (1) für ein Oszilloskop, mit einer Dezimationseinheit (2) und einer Aufzeichnungseinheit (7), wobei die Dezimationseinheit (2) zumindest einen Eingang aufweist, der von zumindest einer Datenquelle (4) einen Datenstrom (5) mit einer Vielzahl von Abtastwerten empfängt,

   wobei die Dezimationseinheit (2) ausgebildet ist, einen Mittelwert aus der Vielzahl von Abtastwerten der Datenquelle (4) zu berechnen,

   wobei die Dezimationseinheit (2) zumindest einen Ausgang aufweist, wobei der berechnete Mittelwert an dem Ausgang als ein reduzierter Datenstrom (11) ausgegeben wird und wobei der reduzierte Datenstrom (11) in der Aufzeichnungseinheit (7) abspeicherbar ist,

   **dadurch gekennzeichnet,**

   **dass** weitere Datenquellen (14), die jeweils eine Vielzahl an Abtastwerten liefern, an die Dezimationseinheit (2) angeschlossen sind wobei die Dezimationseinheit (2) für jede Datenquelle (4, 14) einen eigenen Ausgang aufweist dass die Dezimationseinheit (2) ausgebildet ist, einen quadratischen Mittelwert aus jeweils zumindest zwei Abtastwerten der Datenquelle (4) und jeder weiteren Datenquelle (14) parallel zu berechnen, wobei die berechneten quadratischen Mittelwerte jeder Datenquelle (4, 14) an dem eigenen Ausgang der Dezimationseinheit (2) als der reduzierte Datenstrom (11) ausgegeben und der Aufzeichnungseinheit (7) bereitgestellt werden; und

   **dass** weiterhin eine Triggereinheit (12) in der Messvorrichtung (1) ausgebildet ist, um die Vielzahl von Abtastwerten für j.ede der Datenquellen (4, 14) mit einem für jede der Datenquellen (4, 14) individuell eingestellten Schwellwert zu vergleichen, wobei die Triggereinheit der Aufzeichnungseinheit ausgebildet ist, um ein Triggersignal auszugeben, sobald der reduzierte Datenstrom (11) in der Aufzeichnungseinheit (7) abzuspeichern ist.

2. Messvorrichtung nach Anspruch 1,
   **dadurch gekennzeichnet,**
   **dass** die Dezimationseinheit (2) ausgebildet ist, um den quadratischen Mittelwert $U_{RMS}$ nach der Formel

$$u_{RMS}(k) = \sqrt{\frac{1}{D} \sum_{i=0}^{D-1} (u(k \cdot D + i))^2}$$

mit

D = Dezimierungsfaktor
k = Dezimationsintervall
u = Abtastwert
i = Summationsindex
zu berechnen.

**3.** Messvorrichtung nach Anspruch 1,
**dadurch gekennzeichnet,**
**dass** die Dezimationseinheit (2) ausgebildet ist, um den quadratischen Mittelwert $U_{RMS}$ nach der Formel

$$u_{RMS}(k) = \sqrt{\frac{1}{D} \sum_{i=0}^{\frac{D-1}{n}} (u(k \cdot D + n \cdot i))^2} \quad mit \quad \frac{D-1}{n} \in \mathbb{N} \cap n > 1$$

mit

D = Dezimierungsfaktor
k = Dezimationsintervall
u = Abtastwert
i = Summationsindex
n = kleiner Dezimierungsfaktor
zu berechnen.

**4.** Messvorrichtung nach einem der vorherigen Ansprüche,
**dadurch gekennzeichnet,**
**dass** die Dezimationseinheit (2) ausgebildet ist, um eingestellte Werte für einen Versatz (Offset) ($V_{off}$) bei der Berechnung des quadratischen Mittelwerts zu berücksichtigen.

**5.** Messvorrichtung nach einem der vorherigen Ansprüche,
**dadurch gekennzeichnet,**
**dass** die Aufzeichnungseinheit (7) eine Visualisierungseinheit (10) beinhaltet,
wobei die Visualisierungseinheit (10) ausgebildet ist, um den reduzierten Datenstrom (11) auf einer Bildschirmeinheit darzustellen.

**6.** Messvorrichtung nach einem der vorherigen Ansprüche,
**dadurch gekennzeichnet,**
**dass** es sich bei der Datenquelle (4) um einen Analog/Digital-Wandler handelt und
**dass** der Datenstrom (5) einen Spannungsverlauf oder einen Stromverlauf eines analogen Messsignals (3) wiedergibt.

**7.** Messvorrichtung nach einem der vorherigen Ansprüche,
**dadurch gekennzeichnet,**
**dass** zwischen der Datenquelle (4) und der Dezimationseinheit (2) noch ein Entzerrungsfilter geschaltet ist.

**8.** Verfahren zur Dezimation eines Datenstroms (5) für ein Oszilloskop mit einer Dezimationseinheit (2), deren zumindest einer Eingang den Datenstrom (5) mit einer Vielzahl von Abtastwerten von zumindest einer Datenquelle (4) empfängt und an deren zumindest einem Ausgang ein reduzierter Datenstrom (11) ausgegeben wird und wobei weitere Datenquellen (14), die jeweils eine Vielzahl an Abtastwerten liefern, an die Dezimationseinheit (2) angeschlossen werden und

wobei die Dezimationseinheit (2) für jede Datenquelle (4, 14) einen Ausgang aufweist, wobei an jedem Ausgang ein reduzierter Datenstrom (11, 15) für jede Datenquelle (4, 14) bereit gestellt wird und

wobei eine Triggereinheit (12) des Oszilloskops eine Vielzahl von Abtastwerten für jede Datenquelle (4, 14) mit einem für jede Datenquelle (4, 14) individuell einstellbaren Schwellwert vergleicht,

mit folgenden Verfahrensschritten:

- Einstellen ($S_1$) von Parametern, insbesondere Zeit- und/oder Spannungsbereich;
- Paralleles Berechnen eines quadratischen Mittelwerts aus jeweils zumindest zwei Abtastwerten der Datenquelle (4) und jeder weiteren Datenquelle (14) durch die Dezimationseinheit (2);
- Bilden ($S_2$) des reduzierten Datenstroms (11) aus einem von der Dezimationseinheit (2) berechneten quadratischen Mittelwert aus jeweils zumindest zwei Abtastwerten;
- Ausgeben ($S_3$) des reduzierten Datenstroms (11) am Ausgang der Dezimationseinheit (2);
- Vergleichen der Vielzahl von Abtastwerten für jede der Datenquellen (4, 14) mit einem für jede der Datenquellen (4, 14) individuell eingestellten Schwellwert;
- Ausgeben eines Triggersignal an eine Aufzeichnungseinheit (7), sobald ein für eine der Datenquellen (4, 14) individuell eingestellter Schwellwert überschritten wird wodurch der reduzierte Datenstrom (11) in einer Akquisitionsspeichereinheit (9) einer Aufzeichnungseinheit (7) abgespeichert wird.

9. Verfahren nach Anspruch 8,
**dadurch gekennzeichnet,**
**dass** das Verfahren folgenden Verfahrensschritt aufweist:

- Anzeigen ($S_5$) des gespeicherten reduzierten Datenstroms (11) durch eine Visualisierungseinheit (10) auf einer Bildschirmeinheit.

10. Verfahren nach einem der Ansprüche 8 oder 9,
**dadurch gekennzeichnet,**
**dass** der quadratische Mittelwert $U_{RMS}$ nach der Formel

$$u_{RMS}(k) = \sqrt{\frac{1}{D} \sum_{i=0}^{D-1} (u(k \cdot D + i))^2}$$

mit

D = Dezimierungsfaktor
k = Dezimationsintervall
u = Abtastwert
i = Summationsindex
berechnet wird.

11. Verfahren nach einem der Ansprüche 8 bis 10,
**dadurch gekennzeichnet,**
**dass** sich der quadratische Mittelwert $U_{RMS}$ nach der Formel

$$u_{RMS}(k) = \sqrt{\frac{1}{D} \sum_{i=0}^{\frac{D-1}{n}} (u(k \cdot D + n \cdot i))^2} \quad mit \frac{D-1}{n} \in \mathbb{N} \cap n > 1$$

mit

D = Dezimierungsfaktor
k = Dezimationsintervall

u = Abtastwert
i = Summationsindex
n = kleiner Dezimierungsfaktor
berechnet.

**12.** Verfahren nach einem der Ansprüche 8 bis 11,
**dadurch gekennzeichnet,**
**dass** es sich bei der Datenquelle (4) um einen Analog/Digital-Wandler handelt und
**dass** der Datenstrom (5) einen Spannungsverlauf oder einen Stromverlauf eines analogen Messsignals (3) wiedergibt.

**13.** Verfahren nach einem der Ansprüche 8 bis 12,
**dadurch gekennzeichnet,**
**dass** eingestellte Werte für einen Versatz (Offset) ($V_{off}$) bei der Berechnung des quadratischen Mittelwerts durch die Dezimationseinheit (2) berücksichtigt werden.

**Claims**

**1.** Measuring device (1) for an oscilloscope, with a decimation unit (2) and a recording unit (7), wherein the decimation unit (2) has at least one input which receives a data stream (5) with a multiplicity of sampled values from at least one data source (4), wherein the decimation unit (2) is configured to calculate a mean value from the multiplicity of sampled values of the data source (4), wherein the decimation unit (2) has at least one output, wherein the calculated mean value is outputted at the output as a reduced data stream (11) and wherein the reduced data stream (11) can be stored in the recording unit (7) **characterised in that** further data sources (14), which each supply a multiplicity of sampled values, are connected to the decimation unit (2) and wherein the decimation unit (2) has a specific output for each data source (4, 14), **in that** the decimation unit (2) is configured to calculate a root mean squared value in parallel from in each case at least two sampled values of the data source (4) and each further data source (14), wherein the calculated root mean squared values of each data source (4, 14) are outputted at the specific output of the decimation unit (2) as the reduced data stream (11) and supplied to the recording unit (7); and **in that** furthermore a trigger unit (12) is formed in the measuring device (1) in order to compare the multiplicity of sampled values for each of the data sources (4, 14) with a threshold value set individually for each of the data sources (4, 14), wherein the trigger unit of the recording unit (7) is configured to output a trigger signal as soon as the reduced data stream (11) is to be stored in the recording unit (7).

**2.** Measuring device according to claim 1,
**characterised in that**
the decimation unit (2) is configured to calculate the root mean squared value $U_{RMS}$ according to the formula

$$u_{RMS}(k) = \sqrt{\frac{1}{D}\sum_{i=0}^{D-1}(u(k \cdot D + i))^2}$$

in which

D = decimation factor
k = decimation interval
u = sampled value
i = summation index.

**3.** Measuring device according to claim 1,
**characterised in that**
the decimation unit (2) is configured to calculate the root mean squared value $U_{RMS}$ according to the formula

$$u_{RMS}(k) = \sqrt{\frac{1}{D} \sum_{i=0}^{\frac{D-1}{n}} (u(k \cdot D + n \cdot i))^2} \quad mit \ \frac{D-1}{n} \in \mathbb{N} \cap n > 1$$

in which

> D = decimation factor
> k = decimation interval
> u = sampled value
> i = summation index
> n = small decimation factor.

4. Measuring device according to one of the preceding claims,
**characterised in that**
the decimation unit (2) is configured to take account of set values for an offset (Offset) ($V_{off}$) in the calculation of the root mean squared value.

5. Measuring device according to one of the preceding claims,
**characterised in that**
the recording unit (7) comprises a visualization unit (10),
wherein the visualization unit (10) is configured to display the reduced data stream (11) on a screen unit.

6. Measuring device according to one of the preceding claims,
**characterised in that**
the data source (4) is an analog/digital converter and
**in that** the data stream (5) reproduces a voltage characteristic or a current characteristic of an analog measurement signal (3).

7. Measuring device according to one of the preceding claims,
**characterised in that**
an equalising filter is also connected between the data source (4) and the decimation unit (2).

8. Method for decimation of a data stream (5) for an oscilloscope with a decimation unit (2), the at least one input of which receives the data stream (5) with a multiplicity of sampled values from at least one data source (4) and the at least one output of which outputs a reduced data stream (11) and
wherein further data sources (14), which each supply a multiplicity of sampled values, are connected to the decimation unit (2) and
wherein the decimation unit (2) has an output for each data source (4, 14), wherein a reduced data stream (11, 15) is supplied for each data source (4, 14) at each output and
wherein a trigger unit (12) of the oscilloscope compares a multiplicity of sampled values for each data source (4, 14) with a threshold value which can be set individually for each data source (4, 14),
with the following method steps:

> - setting ($S_1$) of parameters, in particular time range and/or voltage range;
> - parallel calculation by the decimation unit (2) of a root mean squared value from in each case at least two sampled values of the data source (4) and each further data source (14);
> - formation ($S_2$) of the reduced data stream (11) from a root mean squared value calculated by the decimation unit (2) from in each case at least two sampled values;
> - outputting ($S_3$) of the reduced data stream (11) at the output of the decimation unit (2);
> - comparison of the multiplicity of sampled values for each of the data sources (4, 14) with a threshold value set individually for each of the data sources (4, 14);
> - outputting of a trigger signal to a recording unit (7) as soon as a threshold value set individually for one of the data sources (4, 14) is exceeded, through which the reduced data stream (11) is stored in an acquisition storage unit (9) of a recording unit (7).

9. Method according to claim 8,

**characterised in that**
the method comprises the following method step:

- display ($S_5$) of the stored reduced data stream (11) by a visualization unit (10) on a screen unit.

**10.** Method according to one of claims 8 or 9,
**characterised in that**
the root mean squared value $U_{RMS}$ is calculated according to the formula

$$u_{RMS}(k) = \sqrt{\frac{1}{D} \sum_{i=0}^{D-1} (u(k \cdot D + i))^2}$$

in which

D = decimation factor
k = decimation interval
u = sampled value
i = summation index.

**11.** Method according to one of claims 8 to 10,
**characterised in that**
the root mean squared value $U_{RMS}$ is calculated according to the formula

$$u_{RMS}(k) = \sqrt{\frac{1}{D} \sum_{i=0}^{\frac{D-1}{n}} (u(k \cdot D + n \cdot i))^2} \quad mit \quad \frac{D-1}{n} \in \mathbb{N} \cap n > 1$$

in which

D = decimation factor
k = decimation interval
u = sampled value
i = summation index
n = small decimation factor.

**12.** Method according to one of claims 8 to 11,
**characterised in that**
the data source (4) is an analog/digital converter and **in that** the data stream (5) reproduces a voltage characteristic or a current characteristic of an analog measurement signal (3).

**13.** Method according to one of claims 8 to 12,
**characterised in that**
set values for an offset (Offset) ($V_{off}$) are taken into account in the calculation of the root mean squared value by the decimation unit (2).

## Revendications

**1.** Dispositif de mesure (1) pour un oscilloscope, comprenant une unité de décimation (2) et une unité d'enregistrement (7),
l'unité de décimation (2) comprenant au moins une entrée qui reçoit d'au moins une source de données (4) un flux de données (5) présentant une pluralité d'échantillons,
l'unité de décimation (2) étant conçue pour calculer une valeur moyenne à partir de la pluralité d'échantillons de la source de données (4),

l'unité de décimation (2) présentant au moins une sortie, la valeur moyenne calculée étant délivrée à la sortie sous la forme d'un flux de données réduit (11) et

le flux de données réduit (11) pouvant être mis en mémoire dans l'unité d'enregistrement (7),

**caractérisé**

**en ce que** d'autres sources de données (14), qui fournissent respectivement une pluralité d'échantillons, sont raccordées à l'unité de décimation (2), l'unité de décimation (2) présentant pour chaque source de données (4, 14) une entrée propre

**en ce que** l'unité de décimation (2) est conçue pour calculer en parallèle une valeur moyenne quadratique à partir de respectivement au moins deux échantillons de la source de données (4) et de chaque autre source de données (14), les valeurs moyennes quadratiques calculées de chaque source de données (4, 14) étant délivrées à la sortie propre de l'unité de décimation (2) sous la forme du flux de données réduit (11) et remises à l'unité d'enregistrement (7) ; et

**en ce qu'**une unité de déclenchement (12) dans le dispositif de mesure (1) est conçue en outre pour comparer la pluralité d'échantillons pour chacune des sources de données (4, 14) à une valeur seuil réglée individuellement pour chacune des sources de données (4, 14), l'unité de déclenchement de l'unité d'enregistrement (7) étant conçue pour émettre un signal de déclenchement dès que le flux de données réduit (11) est à mettre en mémoire dans l'unité d'enregistrement (7).

2. Dispositif de mesure selon la revendication 1,
**caractérisé**
**en ce que** l'unité de décimation (2) est conçue pour calculer la valeur moyenne quadratique $U_{RMS}$ selon la formule

$$u_{RMS}(k) = \sqrt{\frac{1}{D} \sum_{i=0}^{D-1} (u(k \cdot D + i))^2}$$

dans laquelle

D = facteur de décimation
k = intervalle de décimation
u = échantillon
i = indice de sommation.

3. Dispositif de mesure selon la revendication 1,
**caractérisé**
**en ce que** l'unité de décimation (2) est conçue pour calculer la valeur moyenne quadratique $U_{RMS}$ selon la formule

$$u_{RMS}(k) = \sqrt{\frac{1}{D} \sum_{i=0}^{\frac{D-1}{n}} (u(k \cdot D + n \cdot i))^2}$$

dans laquelle $\frac{D-1}{n} \in N \cap n > 1$     dans laquelle

D = facteur de décimation
k = intervalle de décimation
u = échantillon
i = indice de sommation.
n = facteur de décimation plus petit.

4. Dispositif de mesure selon l'une quelconque des revendications précédentes,
**caractérisé**

**en ce que** l'unité de décimation (2) est conçue pour prendre en compte les valeurs réglées pour un décalage (V_off) lors du calcul de la valeur moyenne quadratique.

5. Dispositif de mesure selon l'une quelconque des revendications précédentes,
   **caractérisé**
   **en ce que** l'unité d'enregistrement (7) comporte une unité de visualisation (10),
   l'unité de visualisation (10) étant conçue pour représenter le flux de données réduit (11) sur une unité d'affichage.

6. Dispositif de mesure selon l'une quelconque des revendications précédentes,
   **caractérisé**
   **en ce que** la source de données (4) est un convertisseur analogique/numérique et
   **en ce que** le flux de données (5) reproduit une variation de tension ou une variation de courant d'un signal de mesure analogique (3).

7. Dispositif de mesure selon l'une quelconque des revendications précédentes,
   **caractérisé**
   **en ce qu'**un filtre d'égalisation est branché en outre entre la source de données (4) et l'unité de décimation (2).

8. Procédé de décimation d'un flux de données (5) pour un oscilloscope au moyen d'une unité de décimation (2), dont au moins une entrée reçoit d'au moins une source de données (4) le flux de données (5) présentant une pluralité d'échantillons et à la ou aux sorties de laquelle un flux de données réduit (11) est délivré et
   d'autres sources de données (14), qui fournissent chacune une pluralité d'échantillons, étant raccordées à l'unité de décimation (2) et
   l'unité de décimation (2) présentant pour chaque source de données (4, 14) une sortie, un flux de données réduit (11, 15) pour chaque source de données (4, 14) étant remis à chaque sortie et
   une unité de déclenchement (12) de l'oscilloscope comparant une pluralité d'échantillons pour chaque source de données (4, 14) à une valeur seuil réglable individuellement pour chaque source de données (4, 14),
   comprenant les étapes de procédé suivantes :

   - le réglage ($S_1$) de paramètres, en particulier la plage de temps et/ou de tension ;
   - le calcul en parallèle d'une valeur moyenne quadratique à partir de respectivement au moins deux échantillons de la source de données (4) et de chaque autre source de données (14) au moyen de l'unité de décimation (2) ;
   - la formation ($S_2$) du flux de données réduit (11) à partir d'une valeur moyenne quadratique calculée par l'unité de décimation (2) à partir de respectivement au moins deux échantillons ;
   - la délivrance ($S_3$) du flux de données réduit (11) à la sortie de l'unité de décimation (2) ;
   - la comparaison de la pluralité d'échantillons pour chacune des sources de données (4, 14) à une valeur seuil réglée individuellement pour chacune des sources de données (4, 14) ;
   - l'envoi d'un signal de déclenchement à une unité d'enregistrement (7), dès qu'une valeur seuil réglée individuellement pour une des sources de données (4, 14) est dépassée, ce qui a pour effet que le flux de données réduit (11) est mis en mémoire dans une unité de mise en mémoire d'acquisition (9) d'une unité d'enregistrement (7).

9. Procédé selon la revendication 8,
   **caractérisé**
   **en ce que** le procédé comprend l'étape de procédé suivante :

   - l'affichage ($S_5$) du flux de données réduit (11) mis en mémoire au moyen d'une unité de visualisation (10) sur une unité d'affichage.

10. Procédé selon l'une quelconque des revendications 8 ou 9,
    **caractérisé**
    **en ce que** la valeur moyenne quadratique U_RMS est calculée selon la formule

$$u_{RMS}(k) = \sqrt{\frac{1}{D}\sum_{i=0}^{D-1}(u(k \cdot D + i))^2}$$

dans laquelle

    D = facteur de décimation
    k = intervalle de décimation
    u = échantillon
    i = indice de sommation.

**11.** Procédé selon l'une quelconque des revendications 8 à 10,
**caractérisé en ce que**
la valeur moyenne quadratique $U_{RMS}$ est calculée selon la formule

$$u_{RMS}(k) = \sqrt{\frac{1}{D} \sum_{i=0}^{\frac{D-1}{n}} (u(k \cdot D + n \cdot i))^2}$$

dans laquelle $\frac{D-1}{n} \in N \ \cap n > 1$ n dans laquelle

    D = facteur de décimation
    k = intervalle de décimation
    u = échantillon
    i = indice de sommation.
    n = facteur de décimation plus petit.

**12.** Procédé selon l'une quelconque des revendications 8 à 11,
**caractérisé**
**en ce que** la source de données (4) est un convertisseur analogique/numérique et
**en ce que** le flux de données (5) reproduit une variation de tension ou une variation de courant d'un signal de mesure analogique (3).

**13.** Procédé selon l'une quelconque des revendications 8 à 12,
**caractérisé**
**en ce que** les valeurs réglées sont prises en compte par l'unité de décimation (2) pour un décalage ($V_{off}$) lors du calcul de la valeur moyenne quadratique.

**Fig. 1**

← Summationsindex i

| | | | | | | | | | |
|---|---|---|---|---|---|---|---|---|---|
| 49 | 48 | 47 | 46 | 45 | 44 | 43 | 42 | 41 | 40 |
| 39 | 38 | 37 | 36 | 35 | 34 | 33 | 32 | 31 | 30 |
| 29 | 28 | 27 | 26 | 25 | 24 | 23 | 22 | 21 | 20 |
| 19 | 18 | 17 | 16 | 15 | 14 | 13 | 12 | 11 | 10 |
| 9 | 8 | 7 | 6 | 5 | 4 | 3 | 2 | 1 | 0 |

| |
|---|
| 4 |
| 3 |
| 2 |
| 1 |
| 0 |

Dezimationsintervall k →

20          21

**Fig. 2**

**Fig. 3**

**Fig. 4**

Start

$S_1$

- Einstellen allgemeiner Parameter in der Messvorrichtung, wie z.B. den Zeitbereich;

$S_2$

- Dezimieren der Abtastwerte, bzw. des Datenstroms, indem der quadratische Mittelwert aus zumindest zwei Abtastwerten durch die Dezimationseinheit gebildet wird;

$S_3$

- Ausgeben der dezimierten Abtastwerte, bzw. des reduzierten Datenstroms an die Aufzeichnungssteuerung;

$S_4$

- Speichern der dezimierten Abtastwerte, bzw. des reduzierten Datenstroms in einem Akquisitionsspeicher durch die Aufzeichnungssteuerung;

$S_5$

- Anzeigen der dezimierten Abtastwerte, bzw. des reduzierten Datenstroms aus dem Akquisitionsspeicher durch die Visualisierungseinheit auf einer Bildschirmeinheit;

Ende

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007053401 A1